# EUROPÄISCHE PATENTSCHRIFT

(11) **EP 0 567 764 B1**
(45) Veröffentlichungstag und Bekanntmachung des Hinweises auf die Patenterteilung: **10.07.1996**
(21) Anmeldenummer: 93104475.4
(22) Anmeldetag: 18.03.1993
(51) Int. Cl.: H01L 31/0224, H01L 31/0236

(54) **Halbleiterkörper mit gut haftender Metallisierung**
Semiconductor body having metallization with good adherence
Corps semiconducteur à métallisation de bonne adhérence

(30) Priorität: 28.04.1992 DE 4213903
(43) Veröffentlichungstag der Anmeldung: 03.11.1993
(73) Patentinhaber: SIEMENS SOLAR GmbH, D-80807 München (DE)
(72) Erfinder: Holdermann, Konstantin, W-8875 Offingen (DE)
(74) Vertreter: Fuchs, Franz-Josef, Dr.-Ing.

(56) Entgegenhaltungen:
- AU-B- 570 309
- PATENT ABSTRACTS OF JAPAN vol. 9, no. 53 (E-301)(1776) 7. Marz 1985
- ELECTRO CONFERENCE RECORDS Bd. 16, 18. April 1991, LOS ANGELES US Seiten 678 - 683 A.NARAYANAN 'Fifty years of crystalline silicon solar cells'
- PATENT ABSTRACTS OF JAPAN vol. 11, no. 4 (E-468)7. Januar 1987 & JP-A-61 179 553
- PATENT ABSTRACTS OF JAPAN vol. 7, no. 148 (E-184)29. Juni 1983 & JP-A-58 060 558
- JOURNAL OF APPLIED PHYSICS. Bd. 69, Nr. 7, 1. April 1991, NEW YORK US Seiten 4135 - 4136 C.M.CHONG ET AL. 'Plasma-grooved, buried contact silicon solar cells'

## Beschreibung

Die Metallisierung von Halbleiterkörpern zur Herstellung von elektrischen Kontakten oder Elektrodenstrukturen auf dem Halbleiterkörper sollte einen guten ohmschen Kontakt mit dem Halbleiter bilden und eine gute Haftung auf dem Halbleiter aufweisen.

Bei Solarzellen müssen über die Vorderseitenkontakte relativ hohe elektrische Ströme bei gleichzeitig möglichst geringer Strukturbreite der Metallisierung bzw. bei minimierter Elektrodenfläche abgeleitet werden. Daher können insbesondere bei Vorderseitenkontakten von Solarzellen Haftungsprobleme der Elektrodenstruktur auf dem Halbleiterkörper der Solarzelle auftreten. Zusätzliche Haftungsprobleme ergeben sich durch die Kontaktierung der Verbindungsbändchen mit der Elektrodenstruktur der Solarzelle.

Im australischen Patent AU-B-57 03 09 wird erstmals vorgeschlagen, die Metallisierung in lasergeschriebenen Gräben zu erzeugen. Weitere Variationen dieser Grabentechnik zur Metallisierung von Solarzellen sind in der älteren deutschen Anmeldung P 42 09 170.5 beschrieben.

Trotz der verbesserten Haftung, die diese versenkte Metallisierung gegenüber konventionell auf der Oberfläche erhaben aufgebrachten Leiterbahnen erbringt, können auch hier Haftungsprobleme auftreten, insbesondere bei den breiteren Busstrukturen, die durch das Anbringen von Verbindungsbündchen zur Verschaltung der Solarzellen einer starken mechanischen Belastung unterliegen.

Aufgabe der vorliegenden Erfindung ist es daher, einen Halbleiterkörper mit einer Metallisierung anzugeben, welche eine verbesserte Haftung auf dem Halbleiter aufweist, und welche in einfacher Weise herzustellen ist.

Diese Aufgabe wird erfindungsgemäß gelöst durch einen Halbleiterkörper mit den Merkmalen von Anspruch 1.

Weitere Ausgestaltungen der Erfindung sowie ein Verfahren zum Erzeugen einer gut haftenden Elektrodenstruktur sind weiteren Ansprüchen zu entnehmen.

Durch die aufgerauhte Oberfläche und die daran angepaßte Metallisierung ergibt sich eine Verzahnung der Metallisierung mit der Halbleiteroberfläche in den Gräben. Da durch die pyramidenförmigen Erhebungen außerdem die Oberfläche des Halbleiters in den Gräben vergrößert ist, vergrößert sich dabei auch die Kontaktfläche zwischen Metallisierung und Halbleiterkörper, so daß daraus eine wesentlich verbesserte Haftung resultiert.

Die pyramidenförmigen Erhebungen können das Ergebnis einer anisotropen kristallorientierten Ätzung sein, wenn der Halbleiterkörper eine kristalline oder zumindest polykristalline Struktur aufweist. Ein solcher auch Texturierung genannter Schritt ist daher auch bei sämtlichen kristallinen und polykristallinen Halbleitermaterialien durchführbar.

Besonders geeignet ist die erfindungsgemäße Metallisierung für die Vorderseitenkontakte von Solarzellen, insbesondere aus kristallinem Silizium.

In vorteilhafter Weise umfaßt das Material der Metallisierung im wesentlichen Silber, welches wegen seiner guten elektrischen Leitfähigkeit bevorzugt ist. Besteht der Halbleiterkörper aus Silizium, so kann aus Gründen einer besseren Haftung eine dünne Palladiumschicht unter der im wesentlichen aus Silber bestehenden Metallisierung vorgesehen sein. Damit wird eine besonders gleichmäßige und gut haftende Metallisierung erreicht. Außerdem kann die Palladiumschicht in einem speziellen Verfahren ausschließlich in den Vertiefungen abgeschieden werden, was die Herstellung einer strukturierten Metallisierung erleichtert.

Im folgenden wird ein Verfahren zur Herstellung dieser Metallisierung anhand eines Ausführungsbeispiels und der dazugehörigen fünf Figuren näher erläutert. Dabei zeigen die Figuren verschiedene Verfahrensstufen anhand eines schematischen Querschnitts durch einen Halbleiterkörper.

Das erfindungsgemäße Verfahren zum Erzeugen der Metallisierung auf der Oberfläche eines Halbleiterkörpers umfaßt die folgenden Schritte:
a) Vorsehen eines der Elektrodenstruktur entsprechenden Musters auf der Oberfläche des Halbleiterkörpers,
b) Ausbilden von Vertiefungen entsprechend dem Muster,
c) naßchemisches kristallorientiertes Ätzen zur Texturierung zumindest des Bodens der Vertiefung,
d) Abscheiden einer Palladiumkeimschicht in den Vertiefungen aus ionogener Palladiumlösung und
e) außenstromlose Abscheidung von zumindest einer weiteren Metallschicht über der Palladiumkeimschicht.

Der Verfahrensschritt a), der der Definition der Elektrodenstruktur (Metallisierung) entspricht, kann über eine Photolacktechnik erfolgen. Das Ausbilden der Gräben entsprechend dem Muster gemäß Schritt b) erfolgt dann über eine naßchemische Ätzung, wobei gegebenenfalls für verschiedene Schichten verschiedene Ätzlösungen erforderlich sein können.

Eine direkte Erzeugung von Gräben (Vertiefungen) in der Oberfläche des Halbleiterkörpers ohne vorherige Definition des Musters kann durch Laserschreiben erfolgen. Ein weiterer alternativer Verfahrensschritt zur gleichzeitigen Durchführung der Schritte a) und b) bietet sich durch die Verwendung eines zum Beispiel diamantbesetzten Werkzeugs zum Ausbilden der Gräben durch Schneiden, Ritzen, Fräsen und dergleichen.

Die kristallorientierte Texturätzung gelingt, wenn ein Ätzmittel gegenüber der vorliegenden Kristalloberfläche eine höhere Ätzgeschwindigkeit zeigt, als gegenüber weiteren, nicht die Oberfläche bildenden Kristallflächen.

Im Ausführungsbeispiel soll mit dem erfindungsgemäßen Verfahren der Vorderseitenkontakt einer Solarzelle aus kristallinem Silizium erzeugt werden. Ausgegangen wird von einem p-leitenden Wafer HL mit (100)-Oberfläche. Eine erste Texturätzung führt zu einer Oberfläche mit pyramidenförmigen Erhebungen PY. Dies vermindert die Reflexion einfallenden Lichts in der späteren Solarzelle und führt zu einer höheren Absorption.

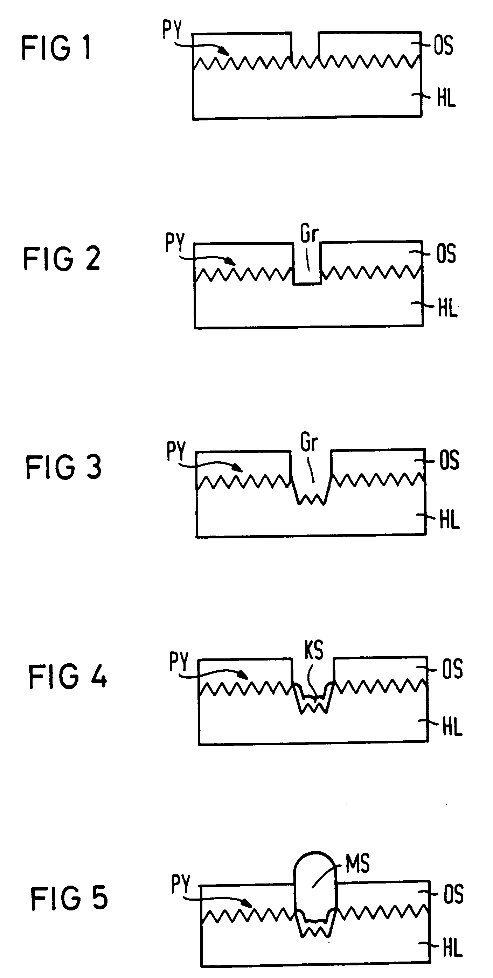

Im nächsten Schritt wird ein flacher pn-Übergang durch Phosphordiffusion erzeugt. Mittels Oxidation bzw. Nitridabscheidung wird nun eine dünne Passivierungsschicht OS über der texturierten Oberfläche ausgebildet. Zur Definition des Elektrodenmusters wird ganzflächig ein Positivphotoresist aufbracht, gemäß dem gewünschten Elektrodenmuster belichtet und schließlich entwickelt. Die verbleibende Resiststruktur dient nun als Ätzmaske bei der Entfernung der ungeschützten Nitrid- bzw. Oxidschicht OS, wobei die Halbleiteroberfläche entsprechend dem Elektrodenmuster freigelegt wird. Figur 1 zeigt die Anordnung nach der Entfernung der Photoresiststruktur.

Zum naßchemischen Ätzen der Gräben Gr dient nun die strukturierte Passivierungsschicht als Maske. Nach einer milden Damage-Ätzung sind Gräben Gr in der Oberfläche des Halbleiters HL erzeugt. Figur 2 zeigt die Anordnung nach diesem Verfahrensschritt.

Mit einer basischen Texturlösung wird nun die im Graben Gr freigelegte Siliziumoberfläche texturiert, wobei sich eine in der Figur 3 dargestellte Anordnung ergibt. Der vor der Texturätzung zum Beispiel plane Grabenboden weist nun ebenfalls pyramidenförmige Erhebungen auf.

Als erste Metallisierungsschicht kann nun eine Palladiumkeimschicht KS spezifisch auf der in den Gräben freigelegten Halbleiteroberfläche erzeugt werden. Nach ca. 30 Sekunden Behandlung in einer ionogenen Palladiumsalzlösung hat sich eine dichte Palladiumkeimschicht KS gebildet (siehe Figur 4).

In zumindest einem weiteren Schritt wird nun die Palladiumkeimschicht KS verstärkt, um eine Metallisierung mit einer für die Stromableitung erforderliche Dicke zu erzeugen. Wie in der älteren deutschen Anmeldung P 42 09 170.5 vorgeschlagen wird, kann dazu zunächst stromlos eine Nickelschicht und darüber elektrolytisch eine Silberschicht bzw. außenstromlos Kupfer abgeschieden werden.

Die Abscheidung der Silberschicht über der Nickelschicht kann auch stromlos erfolgen, wie es zum Beispiel in der älteren deutschen Anmeldung P 42 11 252.4 vorgeschlagen wird, wenn die Abscheidung durch Bestrahlung der Halbleiteroberfläche unterstützt wird. Mit diesem Verfahren gelingt die stromlose Silberabscheidung MS auch direkt über der Palladiumkeimschicht KS.

Figur 5 zeigt die nun fertige Metallisierung KS, MS im schematischen Querschnitt. Diese besitzt eine hervorragende Haftung auf der Halbleiteroberfläche, da sie zum einen in den Graben eingebettet und zum anderen mit dessen texturiertem Grabenboden verzahnt ist.

Mit dem erfindungsgemäßen Verfahren können Metallisierungen in Gräben von zum Beispiel 10 bis 20 µm Breite und entsprechender Tiefe erzeugt werden. Die gleiche Feinheit läßt sich auch mit Laserschreiben erzielen. Bei dieser Variante erfordert das erfindungsgemäße Verfahren gegenüber der bekannten Herstellung einer vergrabenen Metallisierung keinen zusätzlichen Verfahrensschritt, da auch bisher zur Versäuberung des lasergeschriebenen Grabens eine Damage-Ätzung erforderlich war, die nun durch eine Texturätzung ersetzt wird.

Eine Anwendung des erfindungsgemäßen Verfahrens zum Erzeugen von Metallisierungen in polykristallinem Halbleitermaterial führt zu einer weiter verbesserten Haftung der Metallisierung, da hier auch an den Seitenwänden der Gräben eine Verzahnung auf der texturierten Oberfläche mit der Metallisierung erfolgen kann.

## Patentansprüche

1. Halbleiterkörper, der an zumindest einer Oberfläche Vertiefungen (Gr) und in den Vertiefungen eine Metallisierung (KS, MS) aufweist, wobei der Halbleiterkörper (HL) in den Vertiefungen (Gr) eine aufgerauhte Oberfläche mit pyramidenförmige Erhebungen besitzt.

2. Halbleiterkörper nach Anspruch 1, bei dem die Vertiefungen (Gr) grabenförmig angeordnet sind, so daß die Metallisierung eine Elektrodenstruktur ausbildet.

3. Halbleiterkörper nach Anspruch 1 oder 2, wobei der Halbleiterkörper (HL) eine Solarzelle ist.

4. Halbleiterkörper nach einem der Ansprüche 1 bis 3, bei dem die Metallisierung (KS, MS) im wesentlichen eine Silberschicht (MS) über einer dünnen Palladiumschicht (KS) umfaßt.

5. Verfahren zum Erzeugen einer gut haftenden Elektrodenstruktur auf der Oberfläche eines Halbleiterkörpers (HL), welches die folgenden Schritte umfaßt
a) Vorsehen eines der Elektrodenstruktur entsprechenden Musters auf der Oberfläche des Halbleiterkörpers (HL),
b) Ausbilden von Gräben (Gr) in der Oberfläche entsprechend dem Muster,
c) Durchführen einer kristallorientierten naßchemischen Ätzung zur Texturierung zumindest des Grabenbodens wobei pyramidenförmige Erhebungen gebildet werden,
d) Abscheiden einer Palladiumkeimschicht (KS) in den Gräben (Gr) aus einer ionogenen Palladiumlösung und
e) außenstromlose Abscheidung zumindest einer weiteren Metallschicht (MS) über der Palladiumkeimschicht (KS).

6. Verfahren nach Anspruch 5, bei dem das Vorsehen des Musters durch eine Phototechnik und das Ausbilden der Gräben (Gr) durch naßchemische Ätzung erfolgt.

7. Verfahren nach Anspruch 5, bei dem auf der Oberfläche des Halbleiterkörpers zunächst eine Passivierungsschicht (OS) erzeugt wird und bei dem das Vorsehen des Musters und das Ausbilden der Gräben (Gr) direkt und in einem Schritt mittels eines Lasers oder eines mechanischen Werkzeugs erfolgt.

8. Verfahren nach einem der Ansprüche 5 bis 7, bei dem die Abscheidung der weiteren Metallschicht (MS) über der Palladiumkeimschicht (KS) durch Beleuchtung der Halbleiteroberfläche unterstützt wird.

## Claims

1. Semiconductor body, which has indentations (Gr) on at least one surface and a metallization (KS, MS) in the indentations, the semiconductor body (HL) having in the indentations (Gr) a roughened surface with pyramidal raised parts.

2. Semiconductor body according to Claim 1, in which the indentations (Gr) are arranged in trench form, so that the metallization forms an electrode structure.

3. Semicoductor body according to Claim 1 or 2, the semiconductor body (HL) being a solar cell.

4. Semiconductor body according to one of Claims 1 to 3, in which the metallization (KS, MS) essentially contains a silver layer (MS) above a thin palladium layer (KS).

5. Method for the production of an electrode structure, with good adhesion, on the surface of a semiconductor body (HL), which includes the following steps
a) providing a pattern, corresponding to the electrode structure, on the surface of the semiconductor body (HL),
b) forming trenches (Gr) in the surface, in accordance with the pattern,
c) performing a crystal-oriented wet chemical etching in order to texture at least the bottom of the trench, pyramidal raised parts being formed,
d) depositing a palladium seed layer (KS) in the trenches (Gr) from an ion-generating palladium solution, and
e) depositing at least one further metal layer (MS) above the palladium seed layer (KS), without the application of an external current.

6. Method according to Claim 5, in which the pattern is provided by a photographic technique and the trenches (Gr) are formed by wet chemical etching.

7. Method according to Claim 5, in which a passivation layer (OS) is first formed on the surface of the semiconductor body, and in which the pattern is provided and the trenches (Gr) are formed directly, and in one step, by means of a laser or a mechanical tool.

8. Method according to one of Claims 5 to 7, in which the deposition of the further metal layer (MS) above the palladium seed layer (KS) is supported by illumination of the semiconductor surface.

## Revendications

1. Corps semi-conducteur comportant des creusements (Gr) sur au moins une surface et une métallisation (KS, MS) dans les creusements, le corps semi-conducteur (HL) possédant dans les creusements (Gr) une surface rugosifiée par des bosses en forme de pyramide.

2. Corps semi-conducteur selon la revendication 1, dans lequel les creusements (Gr) sont disposés en forme de tranchées, de manière à ce que la métallisation constitue une structure d'électrodes.

3. Corps semi-conducteur selon la revendication 1 ou 2, dans lequel le corps semi-conducteur (HL) est une cellule solaire.

4. Corps semi-conducteur selon l'une des revendications 1 à 3, dans lequel la métallisation (KS, MS) comporte pour l'essentiel une couche d'argent (MS) au-dessus d'une mince couche de palladium (KS).

5. Procédé de réalisation d'une structure d'électrodes à bonne adhérence sur la surface d'un corps semi-conducteur (HL), comportant les étapes suivantes :
a) pose d'un dessin correspondant à la structure d'électrodes sur la surface du corps semi-conducteur (HL),
b) formation de tranchées (Gr) dans la surface correspondant au dessin,
c) réalisation d'une gravure chimique par voie humide orientée selon les cristaux pour texturation d'au moins le fonds de la tranchée, avec formation de bosses en forme de pyramide,
d) dépôt d'une couche de germination en palladium (KS) dans les tranchées (Gr) à partir d'une solution ionogène de palladium et
e) dépôt sans courant extérieur d'au moins une autre couche métallique (MS) sur la couche de germination en palladium (KS).

6. Procédé selon la revendication 5, dans lequel on réalise la pose du dessin par phototechnique et la formation des tranchées (Gr) par gravure chimique par voie humide.

7. Procédé selon la revendication 5, dans lequel on réalise d'abord sur la surface du corps semi-conducteur une couche de passivation (OS), et dans lequel on procède à la pose du dessin et à la formation des tranchées directement et en une seule étape, au moyen d'un laser ou d'un outil mécanique.

8. Procédé selon l'une des revendications 5 à 7, dans lequel le dépôt de la couche métallique supplémentaire (MS) sur la couche de germination en palladium (KS) est assisté par une irradiation de la surface du semi-conducteur.
